(19) Europäisches Patentamt

European Patent Office

Office européen des brevets

(11) **EP 1 085 327 B1**

(12) **EUROPEAN PATENT SPECIFICATION**

(45) Date of publication and mention
of the grant of the patent:
**07.06.2006   Bulletin 2006/23**

(51) Int Cl.:
***G01R 1/073*** *(2006.01)*

(21) Application number: **99610052.5**

(22) Date of filing: **15.09.1999**

(54) **Multi-point probe**

Mehrpunktesonde

Sonde à points multiples

(84) Designated Contracting States:
**AT BE CH CY DE DK ES FI FR GB GR IE IT LI LU
MC NL PT SE**

(43) Date of publication of application:
**21.03.2001   Bulletin 2001/12**

(73) Proprietor: **Capres A/S
2800 Lyngby (DK)**

(72) Inventors:
• **Petersen, Christian Leth
Burnaby, British Columbia V5C 3Y1 (CA)**
• **Quaade, Ulrich
2880 Bagsvaerd (DK)**
• **Nielsen, Peter Folmer
3520 Farum (DK)**
• **Grey, François
01170 Echenerex (FR)**
• **Boggild, Peter
2200 Copenhagen N. (DK)**

(74) Representative: **Nielsen, Henrik Sten et al
Budde, Schou & Ostenfeld A/S
Vester Sögade 10
1601 Copenhagen V (DK)**

(56) References cited:
EP-A- 0 078 339          WO-A-86/06495
WO-A-96/14959          US-A- 5 321 977

## Description

### Field of the invention

The present invention generally relates to a nano-drive for high resolution positioning and for positioning of a multi-point probe and further relates to the technique of testing electric properties on a specific location of a test sample and in particular the technique of probing and analysing semiconductor integrated circuits for example of LSI and VLSI complexity

### Description of the related art

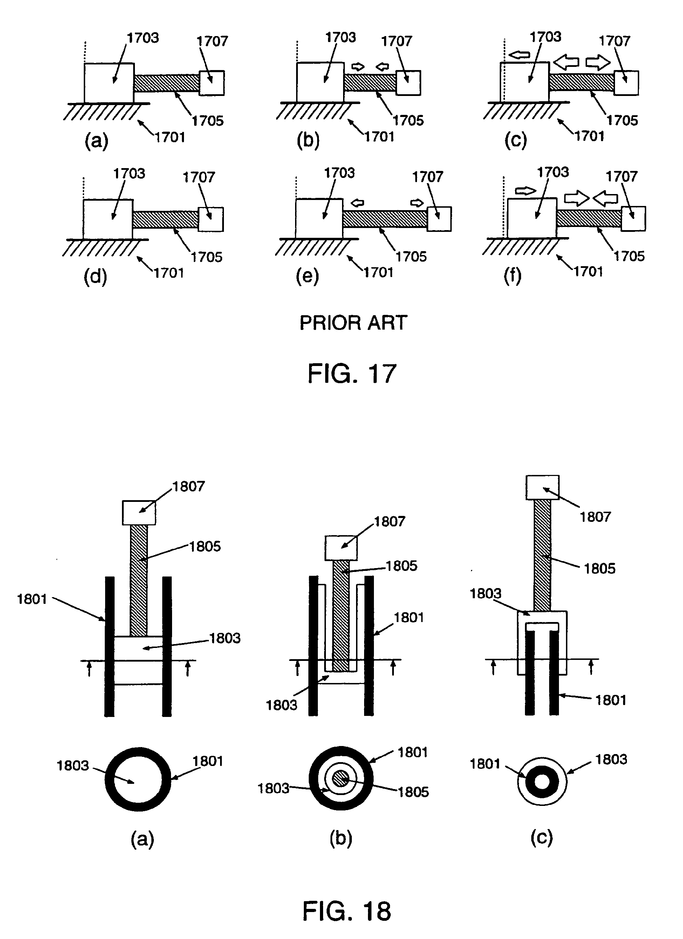

A method for creating very small movements by means of inertial force is known from the literature, for example US pat. 5229679. This method will now be described referring to fig. 17.

An apparatus for creating very small movements according to prior art, comprises a support 1701, a movable part 1703, a piezoelectric element 1705 and an inertial part 1707. The movable part 1703 is held against the support 1701 by means of gravitation or a spring-load. The piezoelectric element can be contracted or elongated by applying an electrical field to the element. If the contraction or elongation occur slowly, the frictional force between the support and the movable part will prevent any movement of the movable part. However, when the electrical field on the movable part changes in such a way that the piezoelectric element contract or elongates quickly, the force on the movable part can exceed the frictional force between the movable part and the substrate, causing the movable part to change its position relative to the substrate with a fraction of a micrometer. In this way a slow contraction followed by a quick elongation will cause the movable part to change position. This is shown in figure 17a-c. By repeated slow contraction and quick elongation of the element, the movable part can travel over several millimeters. The movable part can be made to travel in the opposite direction by repeated quick contraction and slow elongation of the piezoelectric element as shown in figure 17d-f.

In the prior art, only the change in length of the piezoelectric element in the direction of movement is used to create the movement of the movable part. The time dependence of the electrical field on the piezoelectric element for providing the movement is described in the literature as a sawtooth curve-form (for example US Pat. 5568004).

In the prior art, all realizations of the known motion principle use the moving part 1703 to move a body fixed to said part relative to another body which is fixed to the underlying support 1701. Furthermore, in all existing realizations of the known motion principle the frictional forces are induced by outer forces such as gravitational forces, electro-mechanical forces, or external spring-loads in a highly asymmetrical manner.

WO 96/14959 discloses an electromechanical unit for positioning probes. The unit has at least one piezoelectric actuator to transmit electrically controllable inertial movements to a courser.

The following discussion relating to four-point probes is not covered by the appending claims, but is useful for understanding the invention.

The most commonly used technique of testing the electric properties of a test sample involves the generation of resistivity or carrier concentration profiles of the surface of a processed semiconductor wafer by the utilisation of a four-point probe as described in published international patent application WO 94/11745. Furthermore, see for example S.M. Sze, Semiconductor devices - Physics and Technology, Wiley New York (1985).

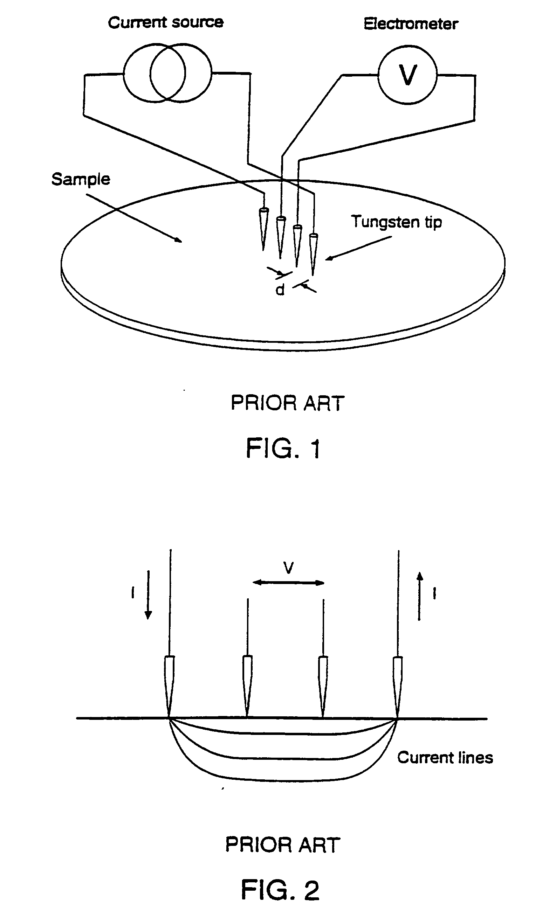

As shown generally in figure 1, the conventional four-point probe technique typically has the points positioned in an in-line configuration. By applying a current to the two peripheral points as shown in detail in figure 2, a voltage can be measured between the two inner points of the four point probe. Thus the electric resistivity of the test sample can be determined through the equation

$$\rho = c \cdot (V/I),$$

wherein **V** is voltage measured between inner points, wherein **I** is current applied to the peripheral points and, wherein **c** is a geometry factor depending on the surface contact separation **d** and the dimensions of the test sample. Several schemes for calculating the correction factors have been developed, see F.M. Smits, *Measurement of Sheet Resistivities with the Four-Point Probe,* Bell System Technical J. 37, 711 (1958), EP 0 299 875 B1, and J. Shi and Y. Sun, *New method for calculation of the correction factors for the measurement of sheet resistivity of a square sample with a square four-point probe,* Rev. Sci. Instrum. 68 1814 (1997).

The four-point probe generally consists of four tungsten or solid tungsten carbide tips positioned into contact with a test sample, being for example a semiconductor wafer. An external positioning system places the four-point probe into physical contact with the semiconductor wafer by moving the four-point probe in a perpendicular motion relative to the wafer surface. Pressure perpendicular to the wafer surface has to be applied to the four-point probe, in order to ensure that all four points obtain physical contact with for example an uneven wafer surface. Hence the pressure from the tips on the surface varies between the tips. The tips are separated by a distance **d,** shown in figure 1, typically in the order of 0.5 mm.

An alternative to the above described four-point probe is the SR (Spreading Resistance) probe, described in US Patent No. 5,347,226 and hereby incorporated in this description by reference. The SR probe consists of two probe tips situated on one cantilever arm. The SR probe is brought into physical contact with wafer surface by an external positioning system, while monitoring the applied pressure such as to accurately control the physical contact to the uneven surface of a semiconductor wafer. However, since the tips are situated on the same cantilever beam the pressure monitored while monitoring the maximum pressure may possibly leave one tip with an inferior physical contact.

Additionally, reference is made to US Patent No. 5,475,318, US Patent No. 5,540,958, US Patent No. 5,557,214, European patent application EP 0 466 274 and European patent application having application number EP 98610023.8, national German patent application DE 196 48 475 and national Japanese patent applications JP 07199219, JP 01147374 and JP H8-15318, which describe the general technical field relating to methods for measuring resistance and to production of measurement probes. The US patents are hereby incorporated in this description by reference. Furthermore, reference is made to Soonil Hong et al's article regarding *design and fabrication of a monolithic high-density probe card for high-frequency on-wafer testing* published in IEEE 1989, pg. 289-292, 7th issue, Changyeol Lee et al's article regarding *high-density silicon microprobe arrays for LCD pixel inspection* published in IEEE 1996, pg. 429-434, 6th issue, T. Fujii et al's article regarding *micropattern measurement with an atomic force microscope* published in Journal of Vacuum Science & Technology B (Microelectronics Processing and Phenomena) 1991 9th issue, pg. 666, H.W.P. Koops et al's article regarding *Constructive three-dimensional lithography with electron beam induced deposition for quantum effect devices* published in Journal of Vacuum Science & Technology B (Microelectronics Processing and Phenomena) 1993 11th issue, pg. 2386, H.W. Koops et al's article regarding *conductive dots, wires, and supertips for field electron emitters produced by deposition on samples having increased temperature* published in Journal of Vacuum Science & Technology B (Microelectronics Processing and Phenomena) 1996 14th issue, pg. 6, and Q. Niu et al's article regarding *double tip scanning tunnelling microscope for surface analysis* published in Physics Rev. B 1995 51st issue pg. 5502.

Furthermore, apart from the above described limitations as to establishing contact with the surface of the test sample to be tested the prior art probes possess limitations as to miniaturisation of the testing technique as the probes hitherto known limit the maximum spacing between any two tips to a dimension in the order of 0.5 mm due to the production technique involving mechanical positioning and arresting of the individual testing pins or testing tips, in particular as far as the four-point probes are concerned, and as far as the SR-probes are concerned exhibit extreme complexity as far as the overall structure is concerned and also certain drawbacks as far as the utilisation of the SR-probe due to the overall structure of the SR-probe.

The above object, the above advantage and the above feature, together with numerous other objects, advantages and features which will be evident from the below detailed description of a presently preferred embodiment of the present invention, are obtained by a first embodiment of a cylindrical nano-drive for in particular driving tools with high resolution and comprising:

a supporting body defining an inner open ended cylindrical space having a first longitudinal axis and an inner cylindrical surface,

a movable member defining an outer contact surface, a first mounting surface and a second mounting surface, said outer contact surface mating said inner open ended cylindrical space, said movable member being inserted into said inner open ended cylindrical space and said contacting surface of said movable member and said inner cylindrical surface of said inner open ended cylindrical space creating a sliding fit between said movable member and said supporting body,

said sliding fit between said movable member and said supporting body being established along the entire area of contact between said inner cylindrical surface and said outer contact surface and being provided by said outer contact surface and said inner cylindrical surface defining therebetween a spacing of a dimension having a size at any specific area of said area of contact of no more than 1 to 5 orders of power of atomic dimensions, preferably 1 to 3, 3 to 5 or 2 to 4, an inertial body having a first proximal end and second proximal end and providing counter weight for said movable member, and

an actuator defining a second longitudinal axis, a third proximal end and a fourth proximal end, said actuator being connected at said third proximal end to said first proximal end of said inertial body and said fourth proximal end of said actuator being connected to said first mounting surface of said movable member, said second longitudinal axis of said actuator being substantially parallel to said first longitudinal axis of said open ended cylindrical space, said actuator moving said movable member in said cylindrical space by contraction and extension of said actuator in a direction parallel to said first longitudinal axis.

The cylindrical nano-drive provides means for high resolution positioning and in particular positioning of a multi-point probe with a high level of accuracy.

The supporting body of the cylindrical nano-drive is constructed from chemically inert and hard materials such as carbides and nitrides and defines an overall triangular, rectangular, elliptical, conical, cubical, spherical or cylindrical outer surface or any combinations thereof, preferably the supporting body defines an overall cylindrical outer surface. The cylindrical outer surface of the supporting body defines a third longitudinal axis substantially coaxial with the first longitudinal axis and the inner open ended cylindrical space defines a circular cross sectional area having an inner diameter.

Likewise the movable member is constructed from chemically inert and hard materials such as carbides and nitrides and defines an overall triangular, rectangular, elliptic, cubical, spherical, conical or cylindrical outer shape or any combinations thereof. Preferably the movable member defines an overall solid cylindrical shape defining the first mounting surface at one end of the solid cylindrical shape and the second mounting surface at the other end of the cylindrical shape. The first and the second mounting surface define a circular area having an outer diameter substantially equal to the inner diameter of the open ended cylindrical surface, so as to provide a sliding fit between the movable member and the supporting body. The movable member defines an overall cylindrical cup shape having an outer diameter substantially equal to the inner diameter of the open ended cylindrical surface constituting a sliding fit between the movable member and the inner cylindrical surface of the supporting body. The movable member defines a bottom inner cup surface constituting the first mounting surface and a bottom outer cup surface constituting the second mounting surface and has the fourth proximal end of the actuator mounted to the first mounting surface with the second longitudinal axis of the actuator being substantially parallel to the first longitudinal axis of the open ended cylindrical space. The overall cylindrical cup shape has an inner diameter substantially equal to the outer diameter of the cylindrical surface of the supporting body constituting a sliding fit between the movable member and the cylindrical surface of the supporting body. The movable member further defines a bottom outer cup surface constituting the first mounting surface and a bottom inner cup surface constituting the second mounting surface and has the fourth proximal end of the actuator mounted to the first mounting surface with the second longitudinal axis of the actuator being substantially parallel to the first longitudinal axis of the open ended cylindrical space.

The inertial body of the nano-drive according to the present invention is constructed from materials such as chemically inert and hard materials such as carbides and nitrides and defines an overall cubical, conical, triangular, rectangular, elliptic, spherical or cylindrical outer shape or any combinations thereof. Preferably the inertial body defines an overall cylindrical shape having a third longitudinal axis connected at the first proximal end to the third proximal of the actuator having the third longitudinal axis and the first longitudinal axis substantially co-axial. Further the inertial body may comprise probing means for performing electric measurements.

The dimensions of the nano-drive and the probe enable the combination to perform high-resolution measurements on test samples. Additionally, the wide variety of possible geometric shapes of the cylindrical nano-drive provides ideal opportunities for customising the cylindrical nano-drive for a wide variety of implementations.

The term cylindrical is to be conceived in the mathematical sense defined as a surface generated by a line, which moves parallel to a fixed line so as to cut a fixed plane curve.

The actuator of the cylindrical nano-drive defines an overall triangular, cubical, conical, rectangular, elliptic, spherical or cylindrical shape or any combinations thereof. Preferably the actuator defines an overall cylindrical shape having circular cross sectional area and is constructed from piezoelectric materials such as quartz. Furthermore the actuator longitudinally and transversely contracts and extends providing a longitudinal movement of the movable member by operating the actuator electrically, magnetically, mechanically, hydraulically or pneumatically or any combinations thereof, preferably by operating the actuator electrically.

The actuator further comprises electrodes mounted onto inner and/or outer surfaces of the actuator for operation of the actuator to longitudinally and transversely contraction and extension by applying electrical signals to the electrodes. The electrical signals are constituted by DC signals and/or AC signals such as alternating square wave signals, alternating triangularly shaped signals or sinusoidal signals or any combinations thereof. By implementing the cylindrical nano-drive according to the third aspect of the invention having actuator operating according to electrical signals in any combinations various advantages are achieved. For example the control of the cylindrical nano-drive may be varied in any desired way to form a desired movement and a desired velocity of the cylindrical nano-drive.

In an embodiment of the cylindrical nano-drive the supporting body defining the inner cylindrical space further defines a tapered extension space section co-axially placed and communicating with the inner cylindrical space and tapering toward the first longitudinal axis leaving reduced access through an aperture to the inner cylindrical space thereby constituting a micro-pipette. This embodiment provides excellent means for removing or delivering fluids at locations where general pipettes cannot reach.

In a further embodiment of the cylindrical nano-drive the supporting body defines the inner cylindrical space in communication with an inner space comprising at least two apertures, the movable member movable into the inner space controlling passage between the at least two apertures thereby constituting a micro-valve. This embodiment provides means for controlling flow of fluids or gases in a wide variety of tubular elements.

The micro-valve and the micro-pipette may have physical dimensions allowing for usage of the micro valve in microscopic robotics or microscopic medico techniques or any other microscopic processing technology.

In a second embodiment of the cylindrical nano-drive according to the present invention the cylindrical nano-drive further comprises a second inertial body defining a distal end and a seventh proximal end and a second actuator defining a fifth proximal end, a sixth proximal end and a fourth longitudinal axis. The fifth proximal end of the second actuator is connected to the seventh proximal end of the second inertial body and the fifth proximal end of the second actuator is connected to the second mounting surface of the movable member. The fourth longitudinal axis of the second actuator is substantially parallel to the first longitudinal axis of the open ended cylindrical space so as to provide a substantially continuous motion of the movable member. By introducing a second actuator on the cylindrical nano-drive the movement of the movable member becomes smoother and therefor a more exact control of the positioning of the movable member is achieve. Thus providing an even better high resolution positioning means:

**Brief description of the drawings**

Additional objects and features of the present invention will be more readily apparent from the following detailed description and appended claims with taken in conjunction with the drawing, in which:

Figure 1, provides an overall illustration of the conventional four-point probe measurement technique on a test sample;

Figure 2, shows a detailed illustration of the measurement technique depicted in figure 1;

Figure 3, depicts the substrate after patterning a deposited support layer;

Figure 4, illustrates the formation of the cantilevers by removal of part of the substrate;

Figure 5, depicts the etching of the substrate to undercut the pattern in the support layer;

Figure 6, depicts the deposition of an electrically conducting layer;

Figure 7, depicts a set-up for measuring a test sample using a multi-point probe:

Figure 8, illustrates a set-up having a multi-point probe mounted on an optical microscope;

Figure 9, pictures a detachable multi-point probe in a semi-conducting wafer;

Figure 10, shows a principal diagram of the circuit used for performing measurements, comprising an electrometer and a current source;

Figure 11, shows an electron beam deposition. (a), shows a perpendicular electron beam disposition and (b), shows a tilted electron beam deposition either on the substrate or as continuation on top of an previously produced tip;

Figure 12, shows metallization of tip. (a), shows in-situ metallization of tip applying conducting contaminants and (b), shows ex-situ metallization of tip applying subsequent metallization;

Figure 13, shows probe geometry having tips extending from probe arms;

Figure 14, shows general tip configurations. (a), shows 2-tip, (b), shows 4-tip having non-uniform tip spacing, (c), shows 4-tip, (d)-(f), shows (a)-(c) having secondary tips;

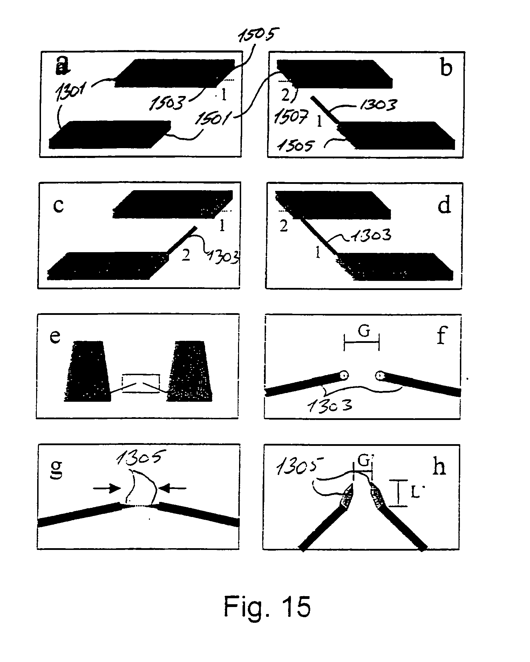

Figure 15, shows tip fabrication of probe. (a), shows initial view. A tip is grown on probe arm 1. (b), shows the sample rotated/tilted hereby obtaining a mirrored view. A tip is grown on probe arm 2 on the pointing line of tip 1. (c)-(d), shows the result of repeating the procedure until the gap G is slightly larger than the intended gap G'. (e), shows the sample rotated to obtain a frontal view, however additionally tilted to obtain the chosen angle a' of the secondary tips. (f)-(g), shows the secondary tips grown on both tip ends. (h), shows the intended gap G' and the lengths tuned by repeating steps (f)-(g);

Figure 16, shows scanning electron microscope pictures of the fabrication sequence (identical to figure 15). (a)-(c), shows initial growth of tip 1 and 2. (d)-(f), shows second iteration. (g)-(I), shows third iteration resulting in gap G' of 300 nm. (j), shows initial growth of secondary tips. (k), shows the secondary tips after narrowing in the gap and fine tuning the lengths to within 10 nm. (l) Overview picture of finished probes;

Figure 17 illustrates the conventional apparatus for effecting fine movement;

Figure 18(a)-(c) are views of embodiments of the nano-positioning apparatus according to the present invention;

Figure 19(a)-(b) are views of a micro-pipette apparatus according to the present invention;

Figure 20(a)-(b) are views of a micro-valve apparatus according to the present invention;

Figure 21 (a)-(c) are views of embodiments of the positioning apparatus according to the present invention;

Figure 22(a)-(c) are curve-forms illustrating the electrical fields to be applied to a single electro-mechanical actuator on the moving member of the present invention for effecting movement of said member;

Figure 23(a)-(b) are curve-forms illustrating the electrical fields to be applied to two electro-mechanical actuators fixed at opposing sides of the moving member of the present invention for effecting movement of said member;

Figure 24 is a view schematically showing a micro-pipette apparatus;

Figure 25 is a view schematically showing a micro-valve apparatus;

Figure 26(a)-(b) are views schematically showing embodiments of a nano-positioning apparatus according to the present invention.

## Detailed description of the preferred embodiments.

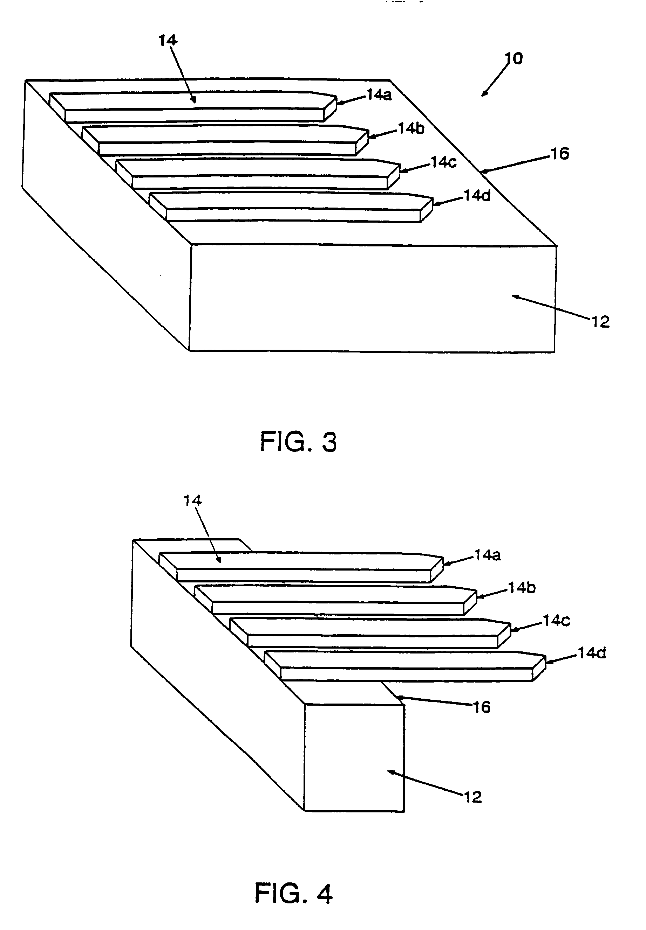

A preferred embodiment is directed toward making a multi-point probe and is described with respect to figures 3-6.

Figure 3 shows a wafer **10**, for example a section of a semiconductor wafer, in intermediate state of fabrication. It shows a surface **16** of a substrate **12** covered by a support layer **14**, being electrically isolating, such as silicon oxide. The deposition of the support layer **14** can be accomplished by any technique known in the art, such as chemical vapour deposition (CVD), plasma enhanced CVD (PECVD), electron cyclotron resonance (ECR) or sputtering. As shown in figure 3, the support layer **14** is patterned and etched to form beams with tapered end-points **14a-d.** The beams are not limited to any particular form or symmetry; they can be of any geometry with suitable end-points.

The pattern is formed by forming a photoresist pattern (not shown in figure 3) which defines the four beams on the top surface of the support layer **14**. The photoresist pattern is formed by conventional photolithographic photoresist formation, exposure, development and removal techniques. The support layer is then etched using any technique known in the art, such as dry etching or wet etching, until the unmasked parts of the support layer **14** are removed from the top surface of the substrate.

In an alternative embodiment the four beams or part of them can be defined using high-resolution lithographic methods such as electron-beam lithography, atomic force microscopy (AFM) lithography or laser lithography.

Once the support layer has been patterned, the substrate is partially removed to release the patterned support layer, forming four cantilevers with sharpened end-points **14a-d**, as illustrated in figure 4.

In the preferred embodiment, the substrate is removed by depositing a protective layer (not shown in figure 4) of silicon nitride on top and bottom surface of the substrate **12.** Next, a photoresist pattern is formed on the bottom surface of the substrate by conventional photolithographic photoresist formation, exposure, development and removal techniques. The nitride layer is then removed in the unmasked areas on the bottom surface of the substrate using Reactive Ion Etch (RIE) in a plasma containing $SF_6$ and $O_2$ or similar reagents, and the substrate is etched using an etching chemistry comprising potassium hydroxide (KOH) or a similar chemistry until the freely extending probe arms are exposed. Then the protecting layer of nitride is removed from the top surface of the substrate using RIE, or using wet etching with a chemistry comprising phosphoric acid ($H_3PO_4$) or a similar chemistry.

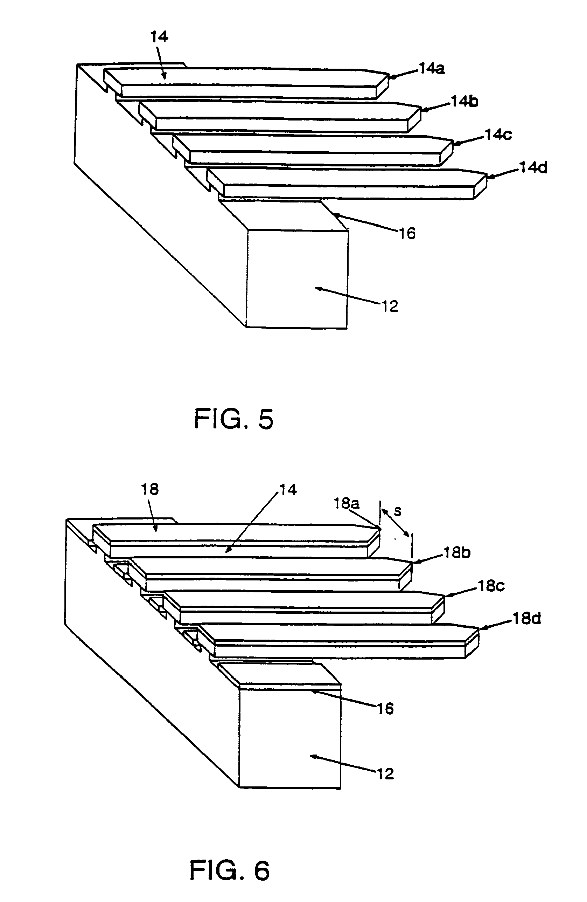

Figure 5, illustrates the etching of the substrate **12** to undercut the support layer **14**. In the preferred embodiment, this etching step is performed with a dry etching method, such as an isotropic RIE etch.

The final stage of fabrication is shown in figure 6, and involves the deposition of an electrically conducting layer **18** on the top surface of the wafer. The conducting layer is made of conducting materials like Au, Ag, Pt, Ni, Ta, Ti, Cr, Cu, Os, W, Mo, Ir, Pd, Cd, Re, conductive diamond, metal silicides or combinations thereof. Alternatively the conducting layer can be made of a highly doped semiconducting material. The conducting layer can be deposited using electron-beam evaporation, or any other similar technique known in the art. Due to the undercutting of the support layer **14,** the electrically conducting layer will not create conducting paths between the four beams made in the support layer, and thus four isolated electrodes are formed on the top surface of the support beams, and thus points **18a-d** can be connected through the beams to an external positioning and measuring device (not shown in figure 6).

As shown in figure 6 the deposition of the conducting layer creates electrodes on the substrate. In a preferred embodiment these electrodes are used for active guarding of the conductive probe arms to significantly reduce leakage resistance and, consequently, increase the measuring accuracy of the invention.

Referring again to figure 6, in the present invention the minimum probe end-point separation **s** is approximately 1$\mu$m. The minimum probe end-point separation is however determined by the current state of the art in micro-fabrication technology and not any limitation of the present invention. Thus, as micro-fabrication technology produces smaller and smaller devices, the minimum probe end-point separation **s** can also be reduced.

In operation an external positioning device places a multi-point probe made according to the present invention into physical contact with the surface of the test sample. Once electrical contact between the surface of the test sample and all four conductive probe arms has been achieved, a current is applied to two of the conductive probe arms and a corresponding voltage is measured between the two other conductive arms. The method for applying the current and detecting the voltage can be any method known in the art.

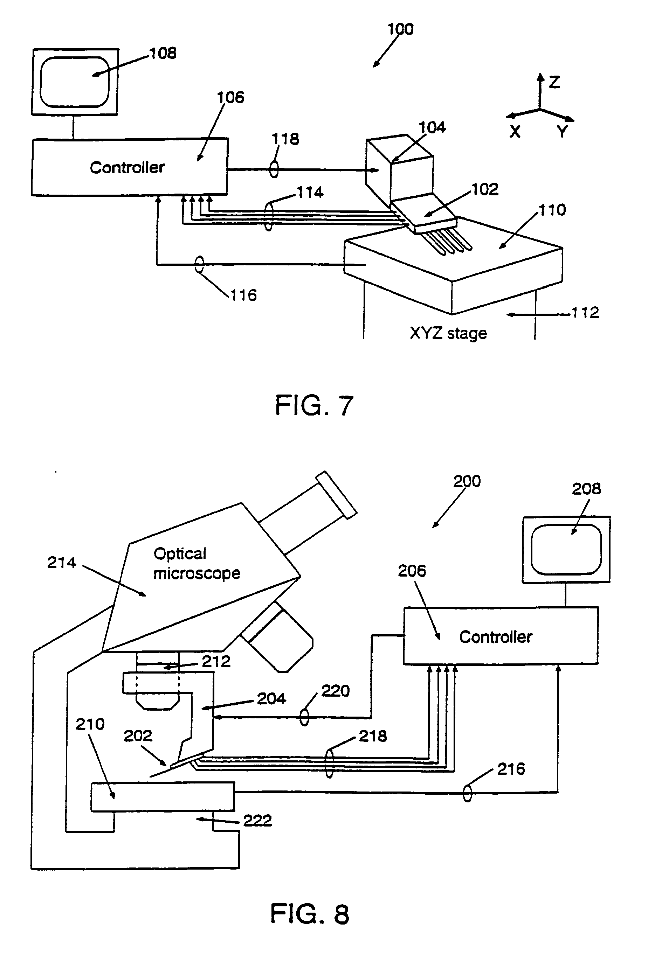

The preferred embodiment of the multi-point testing apparatus of the present invention is shown in figure 7. The figure depicts a multi-point testing apparatus **100**, a test sample **110** is mounted on a stage **112** with an XYZ positioning mechanism. This mechanism can be controlled automatically or manually. A multi-point probe made according to present invention **102** is mounted above the surface of the test sample on a probe holder **104** which can be moved in the Z direction with a resolution of 0.1 μm or better. Optionally the probe holder **104** can be controlled with similar spatial resolution in the X and Y directions. The set-up **100** is similar to that of an AFM or a Scanning Tunnelling Microscope (STM). Connections **114** from the probe end-points are input to a controller **106**, which can move the multi-point probe with respect to the test sample **110.** Optionally a connection **116** from the test sample **110** can also be input to the controller **106**. The controller **106** can be a computer or a programmed micro-controller. By monitoring the four point resistance using the end-points of the four probe arms or the two point resistances between the end-points of the four probe arms and the test sample **110**, the controller **106** can move the multi-point probe towards the test sample until all end-points of the four probe arms are in physical contact with the test sample. By holding the multi-point probe having the probe arm lengths in an angle relative to the surface of the test sample **110**, smaller than perpendicular and larger than parallel, full individual probe arm flexibility is achieved, providing a safe mode of operation in regards to avoiding destruction of single devices on top surface of test sample. Then a measurement can be made of the test sample resistivity, and the controller **106** analyses the measured data and displays measurement information on display **108**. The controller **106** may retract the multi-point probe, move the test sample **110** in the XY plane and repeat the procedure.

Figure 8 illustrates a similar apparatus **200** where the test sample stage consists of a XY positioned **222** on a standard optical microscope **214**. A multi-point probe made in accordance to the present invention **202** is placed on a probe holder **204**, which is mounted on a microscope objective **212**, allowing the operator to identify features on the test sample surface and perform four point probe measurements at these features. In this manner μm sized test sample features such as single microelectronic devices or polycrystalline grains can be probed in a controlled fashion. Similar to the previously described apparatus **100,** illustrated in figure 7, the four leads **218** from the probe are input to a controller **206** as well as a lead **216** connecting to the test sample; the controller outputs signals **220** controlling the movement of the probe holder, and the controller **206** analyses and presents the measurement data on display **208**.

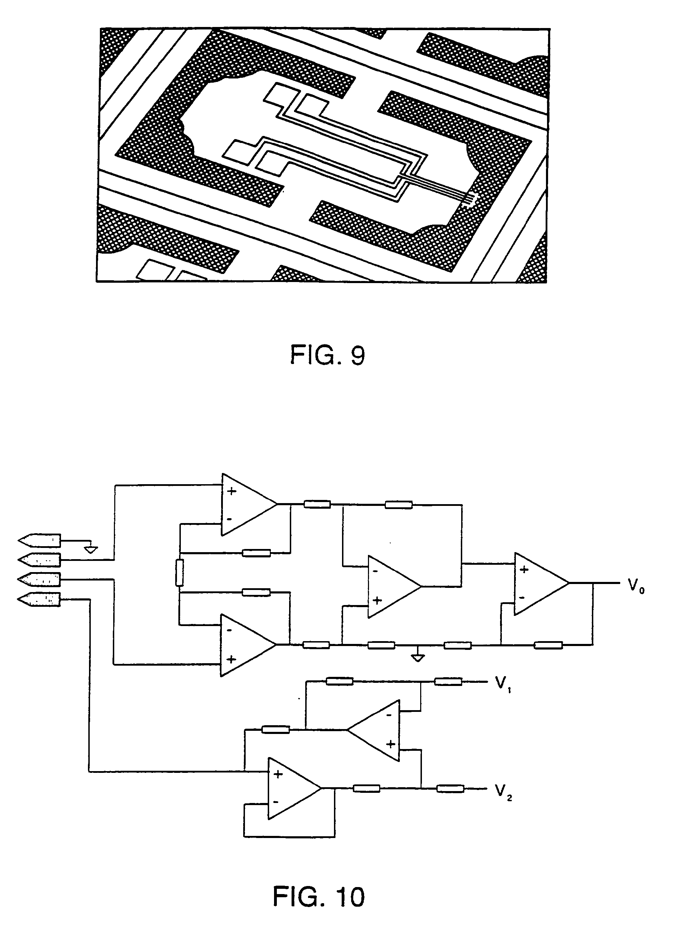

Figure 9, pictures a detachable multi-point probe in a semi-conducting wafer. A wafer can consist of several multi-point probes, which are detachable from the wafer. This production technique provides an extremely repeatable and safe method of fabrication of multi-point probes.

Figure 10, shows a principal diagram of the circuit used for performing measurements, comprising an electrometer and a current source. Applying integrated circuit techniques for the fabrication of multi-point probes enables the possible integration of the electrometer, current source and additional circuit on the wafer.

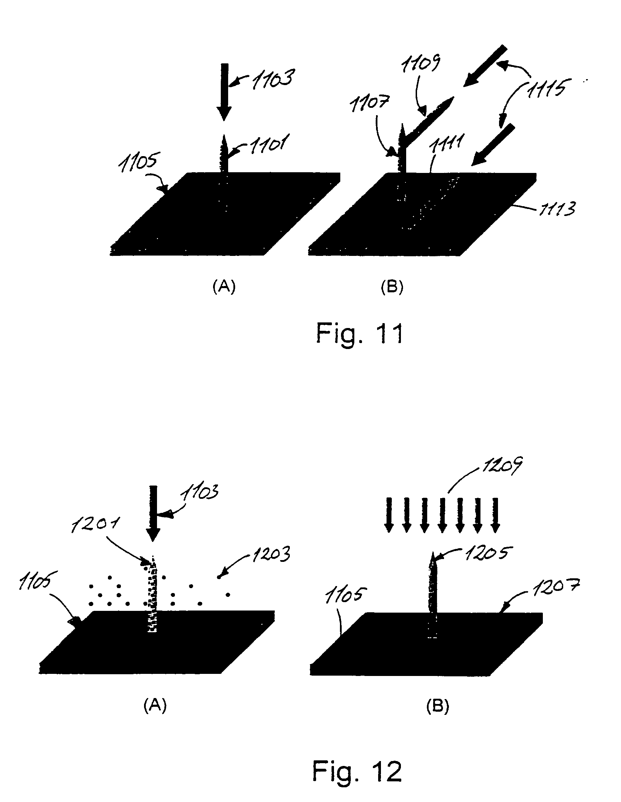

A particular preferred embodiment of the present invention utilises electron beam deposition techniques for growing tips on probe arms. Figure 11 (a), shows such an electron beam deposition grown from a surface **1105** of a probe arm having the electron beam **1103** in a perpendicular relation to the surface thus creating a primary tip **1101** having an axis perpendicular to surface plane. By tilting an electron beam **1115** in relation to a surface **1113** a tilted electron beam deposition grows either on the surface **1113** of substrate as a primary tip **1111** or as a secondary tip **1109** in continuation on top of a previously produced tip **1107** perpendicular to the surface **1113**.

The electric properties of the tips may be modified by applying contaminants **1203** to a tip **1201** utilising an injection of metallo-organic compound at low partial pressure, hereby obtaining tips with resistances as low as 900 Ω (in-situ metallization). The electric properties of the tips may also be modified by applying a metallic cloud or evaporation **1209** creating metallic layers **1205,1207** on the tip **1201** and on the surface **1105** subsequent to finalising the tip growth (ex-situ metallization). By applying subsequent evaporations **1209** using two or more application angles a good metallic coverage of the tip **1101** and the surface **1105** are achieved, thus providing useful tips **1101**. Figure 12, shows both methods for metallization of tips.

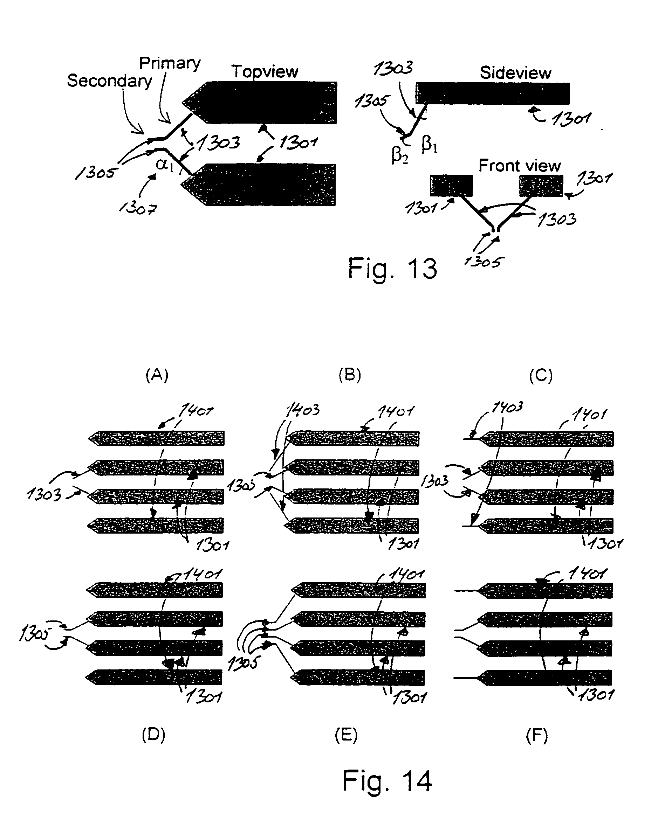

The geometry of a probe is shown in Figure 13 in top view, side view and front view. The probe is shown having to probe arms **1301** on to which primary tips **1303** have been grown by utilising electron beam deposition. The primary tips **1303** create an angle **1307** ($\alpha$1) between direction of axial length of the probe arm **1301** and direction of axial length of primary tips **1303**. Secondary tips **1305** extend from the primary tips **1303** on the probe arms **1301**. The primary tips **1303** furthermore have an inclination **1309** ($\beta$1) and the secondary tip **1305** and additional inclination **1311** ($\beta$2) in relation to the direction of the axial length of the probe arm **1301**.

Several tip configurations are shown in figure 14. Figure 14 (a) shows four parallel probe arms, two outer probe arms **1401** and the two inner probe arms **1301** having two primary tips **1303** positioned on the two inner probe arms **1301**. The two primary tips **1303** create an angle in relation to axial direction of the inner probe arms **1301** such that the primary tips **1303** point a common orientation. Figure 14 (b) shows the four parallel probe arms **1301,1401** having four primary tips **1303,1403** positioned so that the end point have equal tip separations. Figure 14 (c) shows the four probe arms **1301,1401** each having primary tips **1303,1403** extending from distal end. The two inner probe arms **1301** having the primary tips **1303** pointing toward a common orientation and the two outer probe arms **1401** pointing toward in axial direction of the outer probe arms **1401**. Figures 14 (d) to (f) show secondary tips **1305,1405** added to the primary tips **1303,1403.**

The fabrication scheme for producing primary and secondary tips applying electron beam deposition is shown in figure 15. Figure 15 (a) shows the two probe arms **1301** having distal ends defined as **1501** and **1505.** The electron beam is aimed at a corner **1503** of the surface of the distal end **1505**, hereby producing the primary tip **1303**. As shown in figure 15 (b) the electron beam is subsequently aimed at a corner **1507** of the surface of the distal end **1501**, hereby producing the second primary tip **1301**. This procedure is repeated until the separation between the two primary tips **1301** is slightly larger than the intended gap **G'** between the primary tips **1301**. The primary tips **1303** create an angle in relation to axial direction of probe arms **1301** and an angle in relation to the surfaces of the distal ends **1501,1505** such that the primary tips **1303** point away from the supporting body of the multi-point probe. The secondary tips **1305** furthermore create an angle in relation to axial direction of the primary tips **1303.** In order to achieve this secondary angling of the secondary tips **1305** in relation to the primary tips **1301** the multi-point probe is rotated as shown in figure 15(e).

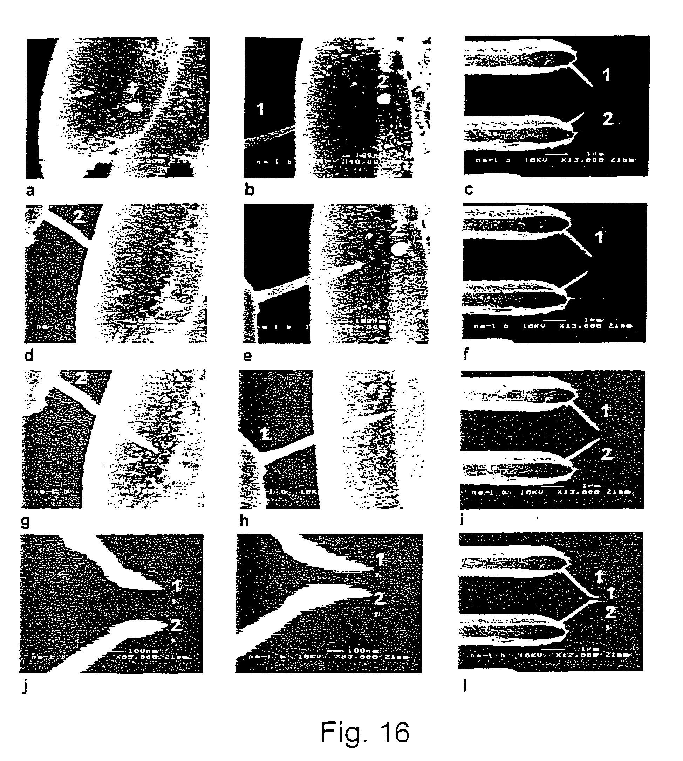

Figure 16, shows electron microscope pictures of the fabrication scheme presented above and in figure 15.

As shown in figure 18a, a preferred embodiment of the cylindrical nano-drive includes a cylindrical movable member 1**803** movably supported in a surrounding substrate **1801**. An electro-mechanical actuator **1805** is fixed on the movable member, and an inertial member **1807** is fixed in the distal end of said actuator. A distributed intrinsic frictional force exists between the movable member and the support. This frictional force originates from the internal elastic forces of the movable member and the support, and appears because of a high-precision machining of the movable member and the support. In a preferred embodiment, the support and the movable member is machined to fit within a tolerance of the diameter of less than one micrometer. This fit can be performed using milling, drilling, etching, honing, polishing, lapping, or any other known technique for machining of materials. In a preferred embodiment the movable member and the support consists of chemically inert, hard materials such as semiconductor carbides or nitrides. The electro-mechanical actuator has at least two electrodes to allow it to be moved in a direction parallel with the travel of the movable member. In a preferred embodiment the electro-mechanical actuator is a piezoelectric tube with one inner electrode and four outer electrodes, to provide both transverse and longitudinal motion of the actuator and thus of the inertial member.

In a second embodiment, the movable member in the cylindrical nano-drive according to the invention is a hollow tube which is closed in one end, as shown in figure 18b. The electro-mechanical actuator is fixed to the bottom of the tube.

In a third embodiment, the movable member in the cylindrical nano-drive according to the invention is a hollow tube which is closed in one end, and is movably supported on the inside of the tube as shown in figure 18c.

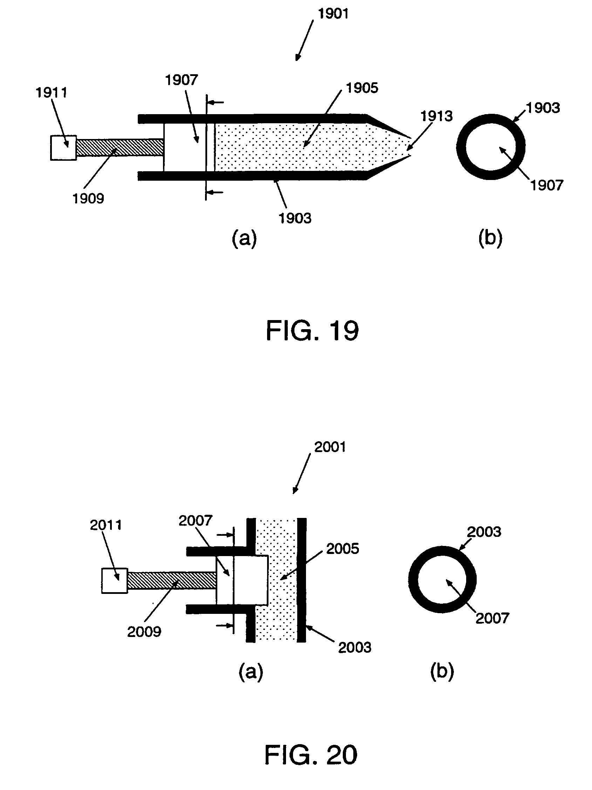

Figure 19a shows an embodiment of a micro-pipette 1901. The micro-pipette consists of a cylindrical nano-drive according to the invention, which has a movable member **1907** movably supported inside a tube **1903**, said tube having an opening **1913** through which very small amounts of liquid or gas can be dispensed or acquired. An electro-mechanical actuator **1909** is fixed to the movable member, and an inertial member **1911** is fixed to the distal end of the actuator. The position of the movable member is controlled by electrical signals applied to the electro-mechanical actuator in such a way that the volume of gas or liquid in the tube is controlled with very high accuracy. Figure 19b shows a sectional view of the micro-pipette.

Figure 20a shows an embodiment of a micro-valve **2001**. The micro-valve consists of a cylindrical nano-drive according to the invention, which has a movable member **2007** movably supported inside a tube **2003** which has two openings through which a gas or liquid **2005** is flowing. The movable member can completely or in part block said flow by applying electrical signals to the electromechanical actuator **2009** which is fixed to the movable member, and thus the flow can be controlled with a very high degree of accuracy. Figure 20b shows a sectional view of the micro-valve.

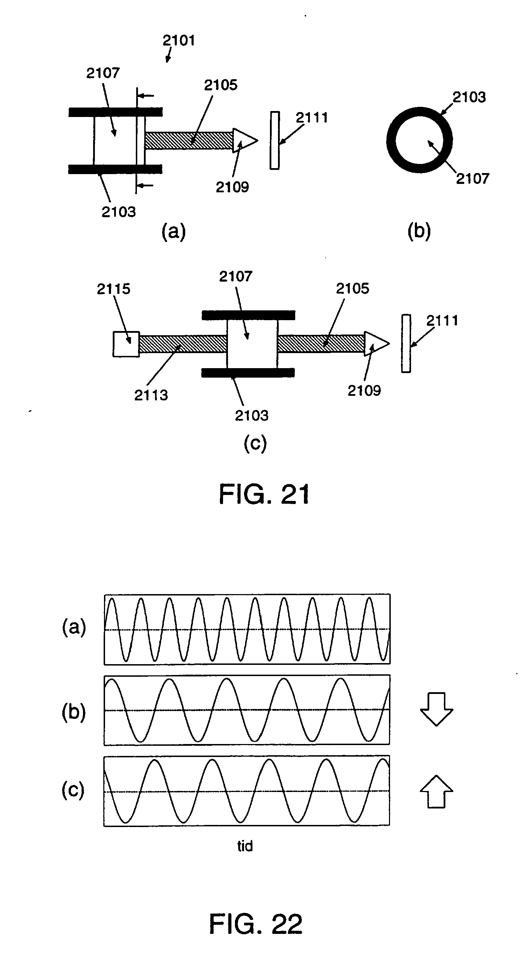

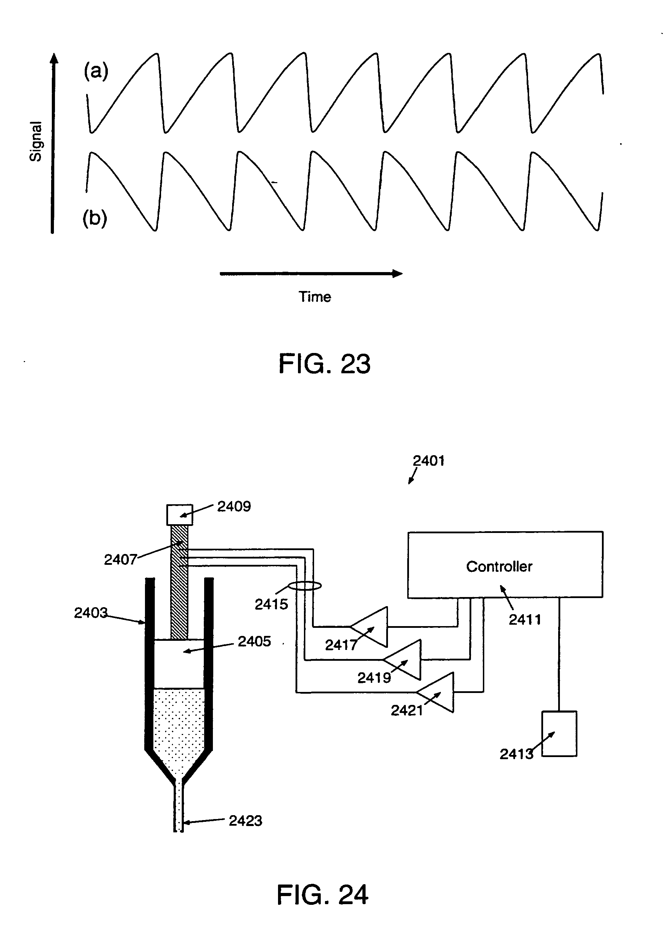

Figure 21a shows an embodiment of a nano-positioner **2101** according to the invention. The nano-positioner consists of a cylindrical nano-drive according to the invention with a movable member movably supported by a tubular substrate **2103**. The position of the substrate can be changed by applying electrical signals to the electro-mechanical actuator **2105**. In the distal end of the actuator is fixed a probe **2109** which is also the inertial member of the cylindrical nano-drive. The probe can be moved in all directions relative to a material **2111** by applying electrical signals to the electro-mechanical actuator. Figure 21b shows a sectional view of the nano-positioner. Figure 21c shows an alternative embodiment of the nano-positioner where the movable member has two actuators fixed at opposing sides. The additional actuator **2107** has an inertial member **2113** fixed at the distal end. The actuator **2113** can be controlled independent of the actuator **2105** which allows the probe to be move continuously over distances of millimeter in the direction of movement of the movable member relative to the material. The electrical fields necessary to achieve this are shown schematically in figures 23a-b. A sawtooth-like waveform is applied to one of the actuators, while a similar waveform of opposing sign is applied to the other actuator. By fine-tuning of the amplitude and phase of the two waveforms, a continuous movement of the probe will appear.

Figures 22a-c shows curve-forms for electrical signals to control the movement of the movable member in a cylindrical nano-drive according to the invention in which the actuator can be moved in both transverse and longitudinal directions. The longitudinal movement of the actuator is controlled by a harmonic oscillating signal as shown in figure 22a. When one or both transverse movements are driven by a harmonic oscillating electrical signal with half the frequency of the longitudinal signal, and when all extrema on the transverse signal coincide with either maxima or minima in the longitudinal signal, then the movable member will be displaced either up or down. These curve-forms are shown in figures 22b-c. By changing the amplitude and the frequency of the harmonic signals, the movement of the movable member per period of the harmonic signal can be made arbitrarily small.

Figure 24 shows schematically a complete micro-pipette apparatus **2401.** The micro-pipette is constructed as described above with reference to figure 19, with the movable member **2405** movably supported inside a tube **2403** which is tapered into a pipette tip **2423.** On the movable member is fixed an electro-mechanical actuator **2407** which has an inertial member **2409** fixed to the distal end. The electrodes on the electro-mechanical actuator are connected to a control-box **2411** through amplifiers **2417 - 2421** with electrical wires **2415.** The control box can include a computer, a microprocessor or discrete digital or analog components. The control box can be controlled remotely by a computer or with a panel **2413** on which the speed and direction of the movable member can be selected.

In a more advanced embodiment of the micro-pipette apparatus, the micro-pipette is attached to a manual or motorized stage, in such a way that the micro-pipette tip can be moved relative to the media in which gas or liquid is to be dispensed or extracted. In the case of an motorized stage, an automatic micro-pipette system is realized, in which the micro-pipette and perform movements synchronized with dispensing or extracting fluid or gas.

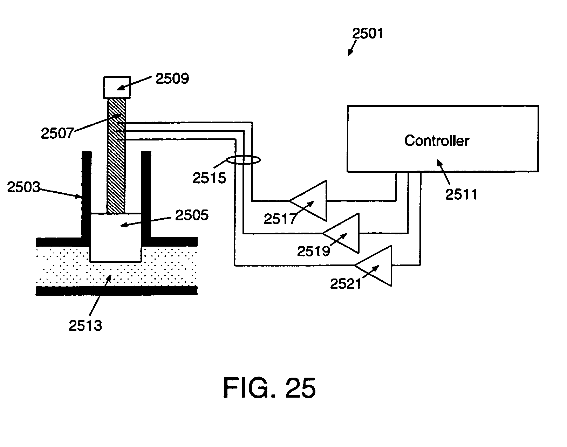

Figure 25 shows schematically a complete micro-valve apparatus **2501.** The micro-valve is constructed as described above with reference to figure 20, with a movable member **2505** movably supported inside a tube **2503** in which a transverse flow of gas or liquid **2513** is present. On the movable member is fixed an electro-mechanical actuator **2507** which has an inertial member **2509** fixed to the distal end. The electrodes on the electro-mechanical actuator are connected to a control-box **2511** through amplifiers **2517 - 2521** with electrical wires **2515.** The control box can include a computer, a microprocessor or discrete digital or analog electronic components.

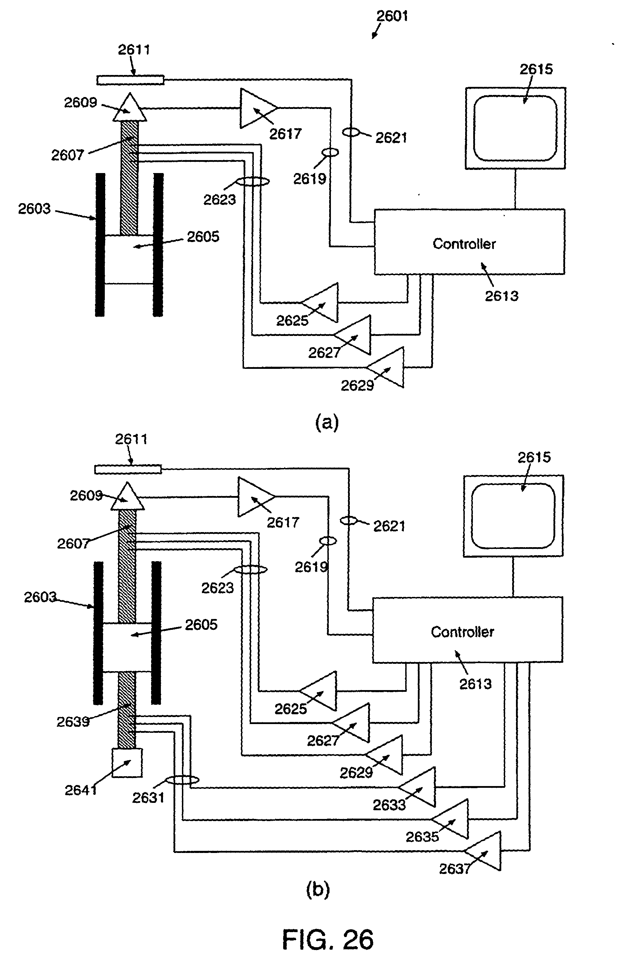

Figure 26a shows schematically a complete nano-positioner apparatus **2601** according to the invention. The nano-positioner apparatus is constructed from an embodiment of the cylindrical nano-drive according to the invention in which the inertial member **2609** comprises a microscopic probe, for example a very sharp electrode. The nano-positioner apparatus can move the probe relative to a sample **2611.** An electrical connection **2619** from the probe can be sent though an amplifier **2617** to a control box **2613.** An electrical connection **2621** can also be made between the sample and the control box. The control box contains a feedback system which uses the electrical signal from the microscopic probe to adjust the position of the microscopic probe relative to the sample. The position of the probe is controlled by at least one electrical connection **2623** between the control box and the electro-mechanical actuator **2607** on the movable member **2605** of the cylindrical nano-drive, which is movably supported in a surrounding substrate **2603.** The electrical signal to the actuator can pass through an amplifier **2625 - 2629.** In a preferred embodiment the actuator comprises a piezoelectric tube with electrodes allowing transversal and longitudinal movement of the microscopic probe with respect to the sample. In this way a scan of the sample material can be obtained as a function of position, and the obtained data can be presented on a display **2615** connected to the control box.

Figure 26b shows an alternative embodiment of the nano-positioner apparatus, further comprising a second electro-mechanical actuator **730** fixed to the movable member of the cylindrical nano-drive according to the invention. A inertial member **732** is fixed to the distal end of the electro-mechanical actuator. There is at least one electrical connection **2631** between the second electro-mechanical actuator and the control box. The electrical signal can pass though an amplifier **2633 - 2637.**

**Example showing the usage of the multi-point probe.**

The probe chips (illustrated in figure 9) are broken out of the wafers and are mounted on ceramic dies (5mm x 10mm) with four big thick-film electrode pads, using epoxy. The conductive probe arms on the silicon chips are connected to the pads on the ceramic dies by bonding 25$\mu$m thick gold wires between them, using a Kulicke-Soffa wedge-bonding machine.

The ceramic chips are fixed mechanically and contacted electrically on an aluminium mount, which is machined to fit around a microscope objective on a Karl-Suss probe station. The mount allows the conductive probe arms of the multi-point probe to be in focus in the middle of the field of view of the microscope. The test sample can then be moved into focus using the normal vertical stage of the microscope. When the test sample is in focus the multi-point probe will contact the test sample and a measurement can be performed. This set-up is similar to the general illustration in figure 8.

Electronics consisting of an electrometer and a current source is built into the aluminium mount to minimise the distance between the probe and the electronics. This keeps the noise in the measurements at a minimum. The principal diagram of the circuit is shown in figure 10.

The two inner conductive probe arms of the multi-point probe are connected to an electrometer (an instrumentation amplifier) with an input impedance of more than 10GΩ and an amplification factor of 5000. The peripheral two conductive probe arms of the probe are connected to the current source (a differential voltage to current converter) which delivers an adjustable output in the range of 10nA to 1μA. The current output is proportional to the voltage difference V1-V2. These voltages are generated externally by a computer equipped with a digital to analogue converter. The same computer detects the output voltage Vo of the electrometer through an attached analogue to digital converter. Batteries power the circuit in order to make it float with respect to ground.

A measurement is performed by sampling the voltage of the electrometer for both polarities of the current, taking the average of the two values. This averaging procedure is useful for eliminating thermal drift in the electronics.

## Claims

1. A cylindrical nano-drive for in particular driving tools with high resolution and comprising
   a supporting body (1801) defining an inner open ended cylindrical space having a first longitudinal axis and an inner cylindrical surface,
   a movable member (1803, 1907, 2007, 2107, 2405, 2505, 2605) defining an outer contact surface, a first mounting surface and a second mounting surface, said outer contact surface mating said inner open ended cylindrical space, said movable member (1803,1907, 2007, 2107, 2405, 2505, 2605) being inserted into said inner open ended cylindrical space and said contacting surface of said movable member (1803, 1907, 2007, 2107, 2405, 2505, 2605) and said inner cylindrical surface of said inner open ended cylindrical space creating a sliding fit between said movable member (1803, 1907, 2007, 2107, 2405, 2505, 2605) and said supporting body (1801),
   said sliding fit between said movable member (1803, 1907, 2007, 2107, 2405, 2505, 2605) and said supporting body (1801) being established along the entire area of contact between said inner cylindrical surface and said outer contact surface and being provided by said outer contact surface and said inner cylindrical surface defining therebetween a spacing of a dimension having a size at any specific area of said area of contact of no more than 1 to 5 orders of power of atomic dimensions, preferably 1 to 3, 3 to 5 or 2 to 4,
   an inertial body (1807, 1911, 2011, 2109, 2409, 2509, 2609) having a first proximal end and second proximal end and providing counter weight for said movable member (1803, 1907, 2007, 2107, 2405, 2505, 2605), and
   an actuator (1805, 1909, 2009, 2105, 2407, 2507, 2607) defining a second longitudinal axis, a third proximal end and a fourth proximal end, said actuator (1805, 1909, 2009, 2105, 2407, 2507, 2607) being connected at said third proximal end to said first proximal end of said inertial body (1807, 1911, 2011, 2109, 2409, 2509, 2609) and said fourth proximal end of said actuator (1805, 1909, 2009, 2105, 2407, 2507, 2607) being connected to said first mounting surface of said movable member (1803, 1907, 2007, 2107, 2405, 2505, 2605), said second longitudinal axis of said actuator (1805, 1909, 2009, 2105, 2407, 2507, 2607) being substantially parallel to said first longitudinal axis of said open ended cylindrical space,
   said actuator (1805, 1909, 2009, 2105, 2407, 2507, 2607) moving said movable member (1803, 1907, 2007, 2107, 2405, 2505, 2605) in said cylindrical space by contraction and extension of said actuator (1805, 1909, 2009, 2105, 2407, 2507, 2607) in a direction parallel to said first longitudinal axis.

2. The cylindrical nano-drive according to claim 1, wherein said cylindrical nano-drive further comprising a second inertial body (2115, 2641) defining a distal end and a seventh proximal end and a second actuator (2113, 2639) defining a fifth proximal end, a sixth proximal end and a fourth longitudinal axis, said fifth proximal end of said second actuator (2113, 2639) being connected to said seventh proximal end of said second inertial body (2115, 2641) and said fifth proximal end of said second actuator (2113, 2639) being connected to said second mounting surface of said movable member (1803, 1907, 2007, 2107, 2405, 2505, 2605), said fourth longitudinal axis of said second actuator (2113, 2639) being substantially parallel to said first longitudinal axis of said open ended cylindrical space so as to provide a substantially continuous motion of said movable member (1803, 1907, 2007, 2107, 2405, 2505, 2605).

## Patentansprüche

1. Zylindrischer Nanoantrieb insbesondere zum Antrieb von hochauflösenden Werkzeugen und umfassend
   einen Tragkörper (1801), der einen inneren offenen zylindrischen Raum definiert, der eine erste Längsachse und eine innere zylindrische Oberfläche aufweist,
   ein bewegliches Teil (1803, 1907, 2007, 2107, 2405, 2505, 2605), das eine äußere Kontakttläche, eine erste Montagefläche und eine zweite Montagefläche definiert, wobei die äußere Kontaktfläche dem inneren offenen zylindrischen Raum angepasst ist, wobei das bewegliche Teil (1803, 1907, 2007, 2107, 2405, 2505, 2605) in den offenen zylindrischen Raum eingefügt ist, und die Kontaktfläche des beweglichen Teiles (1803, 1907, 2007, 2107, 2405, 2505, 2605) und die innere zylindrische Oberfläche des inneren offenen zylindrischen Raums einen Gleitsitz zwischen dem beweglichen Teil (1803, 1907, 2007, 2107, 2405, 2505, 2605) und dem Tragkörper (1801) bilden,

wobei der Gleitsitz zwischen dem beweglichen Teil (1803, 1907, 2007, 2107, 2405, 2505, 2605) und dem Tragkörper (1801) entlang der gesamten Kontaktfläche zwischen der inneren zylindrischen Oberfläche und der äußeren Kontaktfläche hergestellt und **dadurch** geschaffen wird, dass die äußere Kontaktfläche und die innere zylindrische Oberfläche dazwischen einen Zwischenraum von einer Abmessung mit einer Größe auf einem beliebigen spezifischen Gebiet der Kontaktfläche von nicht mehr als 1 bis 5 Größenordnungen von atomaren Abmessungen, bevorzugt 1 bis 3, 3 bis 5 oder 2 bis 4, definieren, einen Trägheitskörper (1807, 1911, 2011, 2109, 2409, 2509, 2609), der ein erstes proximales Ende und ein zweites proximales Ende aufweist und ein Gegengewicht zum beweglichen Teil (1803, 1907, 2007, 2107, 2405, 2505, 2605) schafft, und einen Aktuator (1805, 1909, 2009, 2105, 2407, 2507, 2607), der eine zweite Längsachse, ein drittes proximales Ende und ein viertes proximales Ende definiert, wobei der Aktuator (1805, 1909, 2009, 2105, 2407, 2507, 2607) am dritten proximalen Ende mit dem ersten proximalen Ende des Trägheitskörpers (1807, 1911, 2011, 2109, 2409, 2509, 2609) verbunden ist, und das vierte proximale Ende des Aktuators (1805, 1909, 2009, 2105, 2407, 2507, 2607) mit der ersten Montagefläche des beweglichen Teiles (1803, 1907, 2007, 2107, 2405, 2505, 2605) verbunden ist, wobei die zweite Längsachse des Aktuators (1805, 1909, 2009, 2105, 2407, 2507, 2607) im Wesentlichen parallel zur ersten Längsachse des offenen zylindrischen Raums ist, wobei der Aktuator (1805, 1909, 2009, 2105, 2407, 2507, 2607) das bewegliche Teil (1803, 1907, 2007, 2107, 2405, 2505, 2605) im zylindrischen Raum durch Zusammenziehung und Ausdehnung des Aktuators (1805, 1909, 2009, 2105, 2407, 2507, 2607) in eine zur ersten Längsachse parallele Richtung bewegt.

**2.** Zylindrischer Nanoantrieb nach Anspruch 1, bei dem der zylindrische Nanoantrieb des Weiteren einen zweiten Trägheitskörper (2115, 2641), der ein distales Ende und ein siebtes proximales Ende definiert, und einen zweiten Aktuator (2113, 2639), der ein fünftes proximales Ende, ein sechstes proximales Ende und eine vierte Längsachse definiert, umfasst, wobei das fünfte proximale Ende des zweiten Aktuators (2113, 2639) mit dem siebten proximalen Ende des zweiten Trägheitskörpers (2115, 2641) verbunden ist, und das fünfte proximale Ende des zweiten Aktuators (2113, 2639) mit der zweiten Montagefläche des beweglichen Teiles (1803, 1907, 2007, 2107, 2405, 2505, 2605) verbunden ist, wobei die vierte Längsachse des zweiten Aktuators (2113, 2639)) im Wesentlichen parallel zur ersten Längsachse des offenen zylindrischen Raums ist, um eine im Wesentlichen kontinuierliche Bewegung des beweglichen Teiles (1803, 1907, 2007, 2107, 2405, 2505, 2605) zu schaffen.

**Revendications**

**1.** Nano-entraînement cylindrique, en particulier pour entraîner des outils avec une haute résolution et comprenant

un corps de support (1801) définissant un espace intérieur cylindrique à l'extrémité ouverte ayant un premier axe longitudinal et un espace cylindrique intérieur,

un élément mobile (1803, 1907, 2007, 2107, 2405, 2505, 2605) définissant une surface de contact extérieur, une première surface de montage et une deuxième surface de montage, ladite surface de contact extérieur s'adaptant audit espace intérieur cylindrique à l'extrémité ouverte, ledit élément mobile (1803, 1907, 2007, 2107, 2405, 2505, 2605) étant introduit à l'intérieur dudit espace intérieur cylindrique à l'extrémité ouverte et ladite surface de contact dudit élément mobile (1803, 1907, 2007, 2107, 2405, 2505, 2605) et ladite surface intérieur cylindrique dudit espace intérieur cylindrique à l'extrémité ouverte produisant ainsi un ajustement glissant entre ledit élément mobile (1803, 1907, 2007, 2107, 2405, 2505, 2605) et ledit corps de support (1801),

ledit ajustement glissant entre ledit élément mobile (1803, 1907, 2007, 2107, 2405, 2505, 2605) et ledit corps de support (1801) étant établi le long de l'étendue complète de contact entre ladite surface cylindrique intérieure et ladite surface de contact extérieure et étant constitué par ladite surface de contact extérieure et ladite surface cylindrique intérieure définissant entre les deux un espacement d'une dimension à n'importe quel endroit specifique de ladite étendue de contact qui ne dépasse pas 1 à 5 ordres de grandeur de dimensions atomiques, préférablement 1 à 3, 3 à 5 ou 2 à 4,

Un corps d'inertie (1807, 1911, 2011, 2109, 2409, 2509, 2609) ayant une première extrémité proximale et une deuxième extrémité proximale et fournissant du contrepoids audit élément mobile (1803, 1907, 2007, 2107, 2405, 2505, 2605), et

un actionneur (1805, 1909, 2009, 2105, 2407, 2507, 2607) définissant un deuxième axe longitudinal, une troisième extrémité proximale et une quatrième extrémité proximale, ledit actionneur (1805, 1909, 2009, 2105, 2407, 2507, 2607) étant liée à ladite troisième extrémité proximale à ladite première extrémité proximale dudit corps d'inertie (1807, 1911, 2011, 2109, 2409, 2509, 2609) et ladite quatrième extrémité proximale dudit actionneur (1805, 1909, 2009, 2105, 2407, 2507, 2607) étant liée à ladite première surface de montage dudit élément mobile (1803, 1907, 2007, 2107, 2405, 2505, 2605), ledit deuxième axe longitudinal dudit actionneur (1805, 1909, 2009, 2105, 2407, 2507, 2607) étant essentiellement parallèle au premier axe longitudinal dudit espace cylindrique à l'extrémité ouverte,
ledit actionneur (1805, 1909, 2009, 2105, 2407, 2507, 2607) déplacant ledit élément mobile (1803, 1907, 2007, 2107, 2405, 2505, 2605) dans ledit espace cylindrique par contraction et extension dudit actionneur (1805, 1909, 2009, 2105, 2407, 2507, 2607) dans une direction parallèle au premier axe longitudinal.

2. Le nano-entraînement cylindrique selon la revendication 1, où ledit nano-entraînement cylindrique comprend en outre un deuxième corps d'inertie (2115, 2641) définissant une extrémité distale et une septième extrémité proximale et un deuxième actionneur (2113, 2639) définissant une cinquième extrémité proximale, une sixième extrémité proximale et un quatrième axe longitudinal, ladite cinquième extrémité proximale dudit deuxième actionneur (2113, 2639) étant liée à ladite septième extrémité proximale dudit deuxième corps d'inertie (2115, 2641) et ladite cinquième extrémité proximale dudit deuxième actionneur (2113, 2639) étant liée à ladite deuxième surface de montage dudit élément mobile (1803, 1907, 2007, 2107, 2405, 2505, 2605), ledit quatrième axe longitudinal dudit deuxième actionneur (2113, 2639) étant essentiellement parallèle audit premier axe longitudinal dudit espace cylindrique à l'extrémité ouverte afin de procurer un mouvement continu dudit élément mobile (1803, 1907, 2007, 2107, 2405, 2505, 2605).

PRIOR ART

FIG. 1

PRIOR ART

FIG. 2

FIG. 3

FIG. 4

**FIG. 5**

**FIG. 6**

FIG. 7

FIG. 8

FIG. 9

FIG. 10

(A)　　　　　(B)

Fig. 11

(A)　　　　　(B)

Fig. 12

Fig. 13

Fig. 14

Fig. 15

Fig. 16

PRIOR ART

FIG. 17

FIG. 18

22

FIG. 19

FIG. 20

FIG. 21

tid

FIG. 22

FIG. 23

FIG. 24

FIG. 25

FIG. 26